# EUROPEAN PATENT APPLICATION

(11) **EP 4 697 177 A1**
(43) Date of publication of application: **18.02.2026**
(21) Application number: 24788005.7
(22) Date of filing: 07.04.2024
(51) Int. Cl.: G06F 11/30, G06F 11/32, G06F 1/3203, G01R 31/36

(54) **POWER LEVEL DISPLAY METHOD AND APPARATUS, ELECTRONIC DEVICE, STORAGE MEDIUM, AND PRODUCT**

(30) Priority: 12.04.2023 CN 202310391815
(71) Applicant: GUANGDONG OPPO MOBILE TELECOMMUNICATIONS CORP., LTD., Dongguan, Guangdong 523860 (CN)
(72) Inventor: HE, Zhibin, Dongguan, Guangdong 523860 (CN)
(74) Representative: Penza, Giancarlo
(86) International application number: PCT/CN2024/086434
(87) International publication number: WO 2024/212902

(57) **Abstract**

A power level display method and apparatus, an electronic device, a storage medium, and a product. In the method, an electronic device obtains power level information of a battery of the electronic device through a power level measurement component. When a first operating system runs in foreground of the electronic device, the first operating system acquires, from the power level measurement component, the power level information of the battery as first power level information, and the first power level information is displayed in the first operating system. In response to a system switching instruction, a second operating system runs in the foreground of the electronic device, and second power level information is displayed in the second operating system. The second power level information is acquired based on updated power level information of the battery obtained by the power level measurement component. Since the power level information displayed in the first operating system and the power level information displayed in the second operating system are both obtained through the same power level measurement component, there would be no significant difference in the power level information displayed in the two systems at the time of switching between the systems.

## Description

### CROSS-REFERENCE OF RELATED APPLICATION

This application claims priority to Chinese Patent Application No. 202310391815.6 filed April 12, 2023 and entitled "Power Level Display Method and Apparatus, Electronic Device, Storage Medium, and Product", the entire content of which is incorporated herein by reference.

### TECHNICAL FIELD

The disclosure relates to the technical field of electronic devices, and in particular to a power level display method and apparatus, an electronic device, a storage medium, and a product.

### BACKGROUND

With the increasing functionality of electronic devices, electronic devices equipped with a single operating system would sometimes no longer meet people's needs for the functions of the electronic devices. Therefore, some electronic devices have begun to be equipped with dual operating systems to provide users with a better user experience.

However, when an electronic device equipped with dual operating systems calculates the power level of its battery, there may be differences in power level information calculated by different operating systems. Thus, this leads to significant differences between the power level information displayed in different operating systems.

### SUMMARY

Embodiments of the disclosure provide a power level display method and apparatus, an electronic device, and a computer-readable storage medium, by which the entire power level display process of the electronic device is enabled to be smooth and stable.

In an aspect, a power level display method is provided, which is implemented by an electronic device. The electronic device includes a first chip and a second chip, the first chip is used to run a first operating system, and the second chip is used to run a second operating system. The electronic device further includes a power level measurement component connected to the first chip. The method includes:
obtaining, through the power level measurement component, power level information of a battery of the electronic device;
in a case where the first operating system and the second operating system are all in an enabled state and the first operating system runs in foreground of the electronic device, acquiring, by the first operating system, the power level information of the battery from the power level measurement component as first power level information, and displaying the first power level information in the first operating system; and
in response to a system switching instruction, running the second operating system in the foreground of the electronic device, and displaying second power level information in the second operating system, where the second power level information is acquired based on updated power level information of the battery obtained by the power level measurement component.

In another aspect, a power level display apparatus is provided, which is implemented in an electronic device. The electronic device includes a first chip and a second chip, the first chip is used to run a first operating system, and the second chip is used to run a second operating system. The electronic device further includes a power level measurement component connected to the first chip. The apparatus includes a power level information obtaining module, a first display module and a second display module.

The power level information obtaining module is configured to obtain, through the power level measurement component, power level information of a battery of the electronic device.

The first display module is configured to, when the first operating system and the second operating system are all in an enabled state and the first operating system runs in foreground of the electronic device, enable the first operating system to acquire the power level information of the battery from the power level measurement component as first power level information, and display the first power level information in the first operating system.

The second display module is configured to, in response to a system switching instruction, enable the second operating system to run in the foreground of the electronic device, and display second power level information in the second operating system, where the second power level information is acquired based on updated power level information of the battery obtained by the power level measurement component.

In a further aspect, an electronic device is provided. The electronic device includes a memory and a processor. The memory stores a computer program which, when being executed by the processor, causes the processor to implement operations of the power level display method described above.

In yet a further aspect, a computer-readable storage medium is provided. The computer-readable storage medium stores thereon a computer program which, when being executed by a processor, causes operations of the power level display method described above to be implemented.

In yet a still further aspect, a computer program product is provided. The computer program product includes a computer program which, when being executed by a processor, causes operations of the power level display method described above to be implemented.

In the above power level display method and apparatus, electronic device, storage medium, and product, the electronic device includes a first chip and a second chip, the first chip is used to run a first operating system, and the second chip is used to run a second operating system. The electronic device further includes a power level measurement component connected to the first chip. The electronic device obtains power level information of the battery of the electronic device through the power level measurement component. When the first operating system and the second operating system are all in an enabled state and the first operating system runs in foreground of the electronic device, the first operating system acquires, from the power level measurement component, the power level information of the battery as first power level information, and the first power level information is displayed in the first operating system. In response to a system switching instruction, the electronic device runs the second operating system in the foreground, and displays second power level information in the second operating system. The second power level information is acquired based on updated power level information of the battery obtained by the power level measurement component. Since the power level information displayed in the first operating system and the power level information displayed in the second operating system are both power level information of the battery of the electronic device obtained through the power level measurement component, that is, the power level information obtained in the first operating system and the power level information obtained in the second operating system are consistent, the power level information displayed in the two systems would not jump or change drastically at the time of switching between the two systems. Accordingly, the power level information displayed by the electronic device in different operating systems can remain smooth and stable, avoiding significant differences.

### BRIEF DESCRIPTION OF THE DRAWINGS

To more clearly illustrate technical solutions in the embodiments of the disclosure or in the related art, drawings required for description of the embodiments or the related art are briefly introduced below. Apparently, the drawings in the following description are only some embodiments of the disclosure. For those of ordinary skill in the art, other drawings can be obtained according to the disclosed drawings without creative work.
FIG. 1 illustrates an application environment of a power level display method provided by the embodiments of the disclosure.
FIG. 2 is a flowchart of a power level display method according to an embodiment.
FIG. 3 is a flowchart of a power level display method according to another embodiment.
FIG. 4 is a flowchart of the operation of disconnecting the power level measurement component from the first chip and connecting the power level measurement component to the second chip in response to a system switching instruction as shown in FIG. 3.
FIG. 5 illustrates a system architecture of an electronic device that synchronizes battery power level information in a first operating system and a second operating system according to an embodiment.
FIG. 6 is a flowchart of a method for a second chip to obtain first power level information from a first chip according to an embodiment.
FIG. 7 is a flowchart of a power level display method according to a further embodiment.
FIG. 8 illustrates a system architecture of an electronic device that synchronizes battery power level information in the first operating system and the second operating system according to an embodiment.
FIG. 9 is a flowchart of a power level display method according to an exemplary embodiment.
FIG. 10 illustrates a signaling sequence at which an electronic device synchronizes battery power level information in the first operating system and the second operating system according to an embodiment.
FIG. 11 illustrates a schematic system architecture of the electronic device according to an embodiment.
FIG. 12 is a structural block diagram of a power level display apparatus according to an embodiment.
FIG. 13 is a structural block diagram of a power level display apparatus according to another embodiment.
FIG. 14 illustrates a schematic internal structure of an electronic device according to an embodiment.

### DETAILED DESCRIPTION OF PREFERRED EMBODIMENTS

The technical solutions in the embodiments of the disclosure will be clearly and comprehensively described below with reference to the accompanying drawings in the embodiments of the disclosure. Apparently, the described embodiments are only a part of the embodiments of the disclosure, rather than all the embodiments. All other embodiments, obtained by those of ordinary skill in the art based on the embodiments of the disclosure without creative work, shall fall within the protection scope of the disclosure.

To make the objectives, technical solutions, and advantages of the disclosure clearer, the disclosure is further described in detail below with reference to the accompanying drawings and embodiments. It is understandable that the specific embodiments described herein are only used to explain the disclosure and are not used to limit the disclosure.

It is understandable that the terms "first" and "second" used in the disclosure may be used to describe various elements herein, but these elements are not limited by these terms. These terms are only used to distinguish one element from another. For example, without departing from the scope of the disclosure, a first operating system may be referred to as a second operating system, and similarly, a second operating system may be referred to as a first operating system. Both the first operating system and the second operating system are operating systems, but they are not a same operating system.

With the increasing functionality of electronic devices, electronic devices equipped with a single operating system would sometimes no longer meet people's needs for the functions of the electronic devices. Therefore, some electronic devices have begun to be equipped with dual operating systems to provide users with a better user experience.

Due to different internal software architectures of dual operating systems, different operating systems on an electronic device often use different power level information calculation methods to calculate the power level information of the battery. Therefore, the power level information calculated in different operating systems is different. Alternatively, different operating systems on an electronic device use different power level measurement components to calculate the power level information of the battery. Due to differences between different power level measurement components, the power level information calculated in different operating systems is also different. Thus, while an electronic device equipped with dual operating systems displays the battery's power level, the displayed power level information of the battery would jump or change drastically at the time of switching between the two systems or restarting of system.

For example, in a case where the electronic device is switched from a second operating system (displaying a power level of for example 50%) to a first operating system, the first operating system calculates the power level information as 53% or 45% due to adoption of a different power level calculation algorithm or fluctuations in initial conditions of power level calculation. Apparently, the displayed battery power level information jumps or changes drastically in this case.

For example, after the electronic device runs in the first operating system for a long time, the power drops significantly (e.g., there is only a power level of 3% remained). Then, the electronic device is switched back to the second operating system, and the electronic device initially displays a level of remaining available power of 50% in the second operating system, and it quickly changes to display the actual power level of 3%. In this case, the displayed battery power level information also jumps or changes drastically.

For example, if the electronic device uses different power calculation methods to calculate power level information in the first operating system and the second operating system, after the electronic device runs in the first operating system for a long time, the difference between the power level information calculated by the electronic device in the first operating system and that calculated in the second operating system would be large. Then, at the time of switching between the systems in the electronic device, the displayed battery power level information would jump or change drastically.

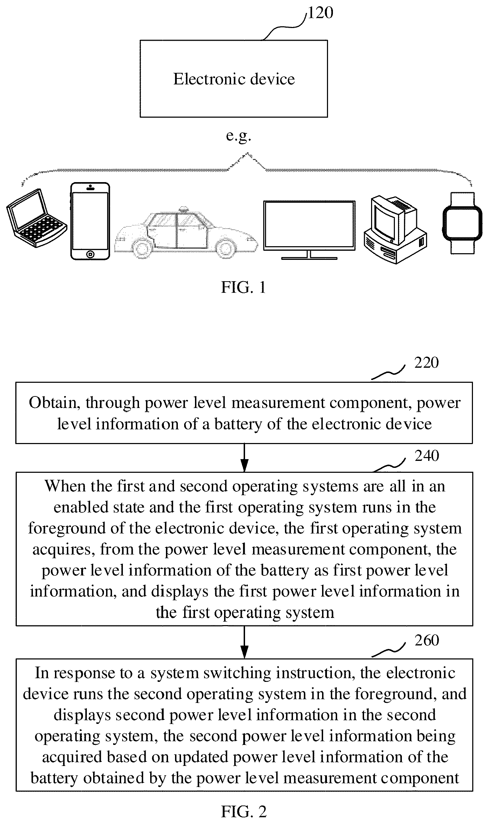

To solve the problem that, while an electronic device equipped with dual systems or multiple systems displays the battery's power level, the displayed battery power level information jumps or changes drastically at the time of switching between the two systems or restarting of system, a power level display method is proposed in the embodiments. FIG. 1 schematically illustrates an application environment of the power level display method provided according to the embodiments. As illustrated in FIG. 1, the application environment includes an electronic device 120. The electronic device 120 includes a first chip and a second chip. The first chip is used to run a first operating system, and the second chip is used to run a second operating system. The electronic device further includes a power level measurement component, and the first chip is connected to the power level measurement component. The electronic device 120 obtains power level information of the battery of the electronic device through the power level measurement component. While the first operating system and the second operating system are all in an enabled state and the first operating system runs in the foreground of the electronic device, the first operating system acquires, from the power level measurement component, the power level information of the battery as first power level information, and displays the first power level information in the first operating system. In response to a system switching instruction, the electronic device runs the second operating system in the foreground, and displays second power level information in the second operating system, where the second power level information is acquired based on updated power level information of the battery obtained by the power level measurement component. The electronic device 120 may be, but is not limited to, various personal computers, notebook computers, smartphones, tablet computers, Internet of Things (IoT) devices, and portable wearable devices. The IoT devices may be smart speakers, smart TVs, smart air conditioners, smart in-vehicle devices, smart cars, etc. The portable wearable devices may be smart watches, smart bracelets, head-mounted devices, etc.

FIG. 2 is a flowchart of a power level display method according to an embodiment. In the embodiment, it is illustrated by taking a case where the power level display method is implemented by the electronic device shown in FIG. 1 as an example. The electronic device includes a first chip and a second chip. The first chip is used to run a first operating system, and the second chip is used to run a second operating system. The electronic device further includes a power level measurement component, and the first chip is connected to the power level measurement component. As illustrated in FIG. 2, the power level display method includes operations 220 to 260.

In operation 220, power level information of a battery of the electronic device is obtained through the power level measurement component.

Here, the power level measurement component refers to a component used for power level measurement in the electronic device. The power level measurement component may include a voltameter/fuel gauge (FG), but the disclosure is not limited thereto. A power-supply battery uniformly supplies power to the first operating system (System_A) and the second operating system (System_B) through a power supply bus. A fuel gauge FG is connected on the power supply bus. The fuel gauge may collect the charging current and discharging current of the power-supply battery in real time through a CSP pin and a CSN pin, and calculate the power level information of the battery based on the charging current and discharging current; or it may collect the charging voltage and discharging voltage of the power-supply battery in real time, and calculate the power level information of the battery based on the charging voltage and discharging voltage. Thus, the electronic device can obtain, in real time, the power level information of the battery of the electronic device through the power level measurement component.

Here, the power level information includes at least one of information on remaining available power of the battery, a power mode of the battery, information on state of charge (SOC) of the battery, lifespan information of the battery, a total capacity of the battery, and other information. The power mode of the battery includes a normal mode, a power-saving mode, an ultra-power-saving mode, etc., and the disclosure is not limited thereto. It is understandable that, when the battery of the electronic device is in the normal mode, all applications on the electronic device can be started normally; when the battery of the electronic device is in the power-saving mode, some applications on the electronic device (e.g., communication-related applications) can be started normally; and when the battery of the electronic device is in the ultra-power-saving mode, only applications that support basic functions of the system (such as, a clock application and a GPS application) can be started normally, and other applications cannot be started.

In operation 240, when the first operating system and the second operating system are all in an enabled state and the first operating system runs in the foreground of the electronic device, the first operating system acquires, from the power level measurement component, the power level information of the battery as first power level information, and displays the first power level information in the first operating system.

First, the electronic device detects whether both the first operating system and the second operating system are in an enabled state. Here, the first operating system may be any one of an MCU system, an Android system, and a Symbian system, and the second operating system may also be any one of an MCU system, an Android system, and a Symbian system, and the disclosure is not limited thereto. Moreover, the first operating system and the second operating system are different operating systems. When the first operating system and the second operating system are all in the enabled state, in order to avoid the problem that the displayed battery power level information jumps or changes drastically at the time of switching between the two systems of the electronic device, the electronic device needs to synchronize the battery power level information between the first operating system and the second operating system. Synchronization of the battery power level information between the first operating system and the second operating system can improve the consistency of the battery power level information acquired in the first operating system and the battery power level information acquired in the second operating system. In other words, the improvement of consistency can be understood as reducing the difference between the battery power level information acquired in the first operating system and that acquired in the second operating system.

Then, when the first operating system runs in the foreground of the electronic device, that is, the first operating system is in a state of running in foreground, the interface(s) and applications of the first operating system run on the electronic device, and the second operating system is in a state of running in background. As such, when the first operating system is in the state of running in foreground, it needs to display the battery power level information in the first operating system.

Then, the first operating system acquires, from the power level measurement component, the power level information of the battery as first power level information, and displays the first power level information in the first operating system. In some implementations, the first operating system may send the first power level information acquired from the power level measurement component to a battery service (BatteryService), and then the BatteryService reports the first power level information to the UI interface under the first operating system or applications under the first operating system. Then, after receiving the first power level information of the battery under the first operating system, the UI interface under the first operating system may render and display the first power level information of the battery on the UI interface under the first operating system based on this power level information.

After receiving the first power level information of the battery under the first operating system, in response to the first power level information, the applications under the first operating system may adjust a running state, a running parameter(s), or a running mode of these applications, and the disclosure is not limited thereto. For example, if the applications under the first operating system receive the first power level information of the battery under the first operating system as 20%, in response to the first power level information of 20%, the applications under the first operating system are controlled to enter the power-saving mode, and the disclosure is not limited thereto. The first power level information mentioned here is not limited to 20%, it may also be 15% or 25%, and the disclosure is not limited thereto.

In operation 260, in response to a system switching instruction, the electronic device runs the second operating system in the foreground, and displays second power level information in the second operating system, where the second power level information is acquired based on updated power level information of the battery obtained by the power level measurement component.

When the first operating system is in the state of running in foreground, the first power level information of the battery is displayed in the first operating system. Then, if the electronic device receives a system switching instruction which may be an instruction sent from the first operating system to the second operating system and which carries wake-up information, in responds to the system switching instruction, the second operating system may be woken up based on the wake-up information. After the second operating system is woken up, the electronic device runs the second operating system in the foreground, that is, the second operating system is in the state of running in foreground at this time, and interface(s) and applications of the second operating system run on the electronic device. The interface(s) and applications of the second operating system running on the electronic device may be different from the interface(s) and applications of the first operating system running on the electronic device. In this case, the first operating system is in the state of running in background.

Therefore, when the second operating system is in the state of running in foreground, the second power level information of the battery may be displayed in the second operating system. In some implementations, the second operating system of the electronic device may acquire the second power level information based on updated power level information of the battery obtained by the power level measurement component. Then, the second operating system may send the second power level information of the battery to the battery service (BatteryService), and then the BatteryService reports the second power level information to a UI interface under the second operating system or applications under the second operating system. Then, after receiving the second power level information of the battery under the second operating system, the UI interface under the second operating system may render and display the second power level information of the battery on the UI interface under the second operating system based on the second power level information.

After receiving the second power level information of the battery under the second operating system, in response to the second power level information, the applications under the second operating system may adjust a running state, a running parameter(s), or a running mode of these applications, and the disclosure is not limited thereto. For example, if the applications under the second operating system receive the second power level information of the battery under the second operating system as 20%, in response to the second power level information of 20%, the applications under the second operating system are controlled to enter the power-saving mode, and the disclosure is not limited thereto. The second power level information mentioned here is not limited to 20%, it may also be 15% or 25%, and the disclosure is not limited thereto.

In the embodiments of the disclosure, the electronic device obtains the power level information of the battery of the electronic device through the power level measurement component. When the first operating system and the second operating system are all in the enabled state, and the first operating system runs in the foreground of the electronic device, the first operating system acquires, from the power level measurement component, the power level information of the battery as first power level information, and displays the first power level information in the first operating system. In response to the system switching instruction, the electronic device runs the second operating system in the foreground, and displays second power level information in the second operating system, where the second power level information is acquired based on updated power level information of the battery obtained by the power level measurement component. Since the power level information displayed in the first operating system and the power level information displayed in the second operating system are both power level information of the battery of the electronic device obtained through the power level measurement component, that is, the power level information acquired in the first operating system and the power level information acquired in the second operating system are consistent, the power level information displayed on each of the two systems would not jump or change drastically at the time of switching between the two systems. Thus, the electronic device is enabled to make the power level information displayed in different operating systems smooth and stable, and significant differences between such displayed power level information is avoided.

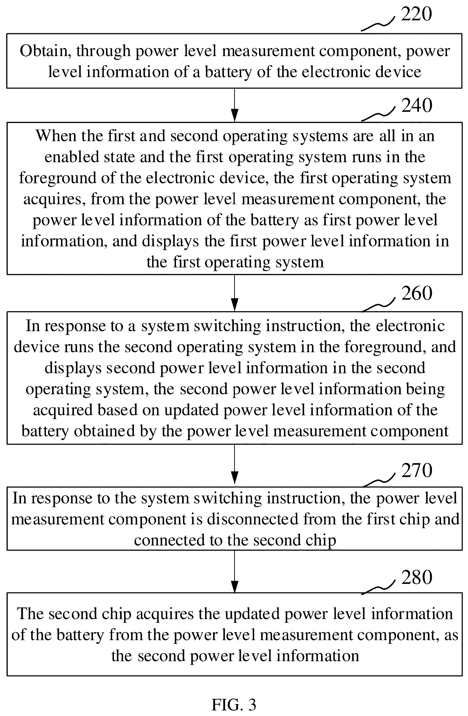

In the previous embodiment, a process is described in which, when the first operating system runs in the foreground of the electronic device, the first operating system acquires, from the power level measurement component, the power level information of the battery as first power level information, and displays the first power level information in the first operating system; and in response to the system switching instruction, the electronic device runs the second operating system in the foreground and displays second power level information in the second operating system. In this embodiment, as illustrated in FIG. 3, the provided power level display method further includes operations 270 and 280.

In operation 270, in response to the system switching instruction, the power level measurement component is disconnected from the first chip, and the power level measurement component is connected to the second chip.

In operation 280, the second chip acquires the updated power level information of the battery from the power level measurement component, and takes the updated power level information of the battery as the second power level information.

The first chip is a Microcontroller Unit (MCU), and the second chip is a System on Chip (SOC); accordingly, the first operating system is an MCU system, and the second operating system is an Android system. Alternatively, the first chip is a System on Chip (SOC), and the second chip is a Microcontroller Unit (MCU); accordingly, the first operating system is an Android system, and the second operating system is an MCU system. The disclosure is not limited thereto.

By default, the first chip is kept connected with the power level measurement component in the electronic device. In this case, when the first operating system runs in the foreground of the electronic device, the first operating system may directly acquire, from the power level measurement component, the power level information of the battery as the first power level information, and display the first power level information in the first operating system.

Then, if the electronic device receives the system switching instruction, in response to the system switching instruction, the electronic device controls the power level measurement component to be disconnected from the first chip, and controls the power level measurement component to be connected to the second chip. In this way, the second chip may acquire the updated power level information of the battery from the power level measurement component, and take the updated power level information of the battery as the second power level information.

In the embodiments of the disclosure, when the electronic device receives the system switching instruction, in response to the system switching instruction, the electronic device controls the power level measurement component to be disconnected from the first chip, and controls the power level measurement component to be connected with the second chip. Then, the second chip may acquire the updated power level information of the battery from the power level measurement component, and take the updated power level information of the battery as the second power level information. As such, while the first operating system runs in the foreground of the electronic device, the first operating system acquirers, from the power level measurement component, the power level information of the battery as the first power level information; and while the second operating system runs in the foreground of the electronic device, the second operating system also acquires, from this power level measurement component, the updated power level information of the battery as the second power level information. In this way, the first operating system and the second operating system are enabled to acquire the power level information from the same power level measurement component. Thus, even if the system switching occurs, the power level information displayed on the two systems would not jump or change drastically.

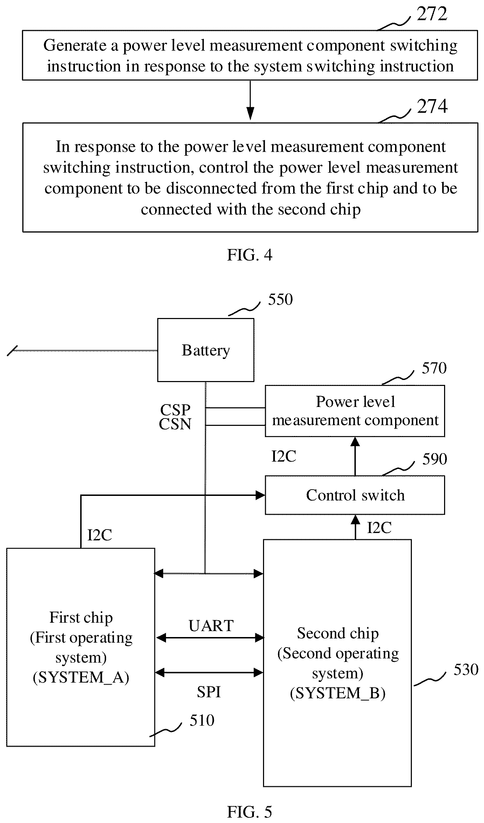

In the previous embodiment, an implementation is described in which both the first operating system and the second operating system acquire the power level information from the same power level measurement component. In this embodiment, it is further described that the electronic device further includes a control switch, and the control switch is connected to the power level measurement component. As illustrated in FIG. 4, the operation 270 of disconnecting the power level measurement component from the first chip and connecting the power level measurement component to the second chip in response to the system switching instruction, includes operations 272 and 274.

In operation 272, a power level measurement component switching instruction is generated in response to the system switching instruction.

The power level measurement component switching instruction refers to an instruction used to control the power level measurement component to be disconnected from its currently connected chip and switch to being connected to another chip. Exemplarily, in response to the system switching instruction, the electronic device not only triggers the operation of switching the operating system, but also triggers the generation of the power level measurement component switching instruction.

In a case where the first operating system runs in the foreground by default on the electronic device, in response to the system switching instruction, it is detected whether the second operating system runs in the foreground of the electronic device. If it is detected that the second operating system runs in the foreground of the electronic device, the power level measurement component switching instruction is generated. For example, when the MCU system runs in the foreground by default on the electronic device, in response to the system switching instruction, it is detected whether the Android system runs in the foreground of the electronic device. If it is detected that the Android system runs in the foreground of the electronic device, the power level measurement component switching instruction is generated.

In operation 274, in response to the power level measurement component switching instruction, the power level measurement component is controlled, through the control switch, to be disconnected from the first chip and to be connected with the second chip.

Assuming that the power level measurement component is connected with the first chip at the current moment, in response to the power level measurement component switching instruction, the electronic device controls, through the control switch, the power level measurement component to be disconnected from the first chip, and controls the power level measurement component to be connected with the second chip.

FIG. 5 illustrates a system architecture of the electronic device that synchronizes the battery power level information in the first operating system and the second operating system according to an embodiment. The electronic device includes a first chip 510 and a second chip 530. The first chip 510 is used to run a first operating system (System_A), and the second chip 530 is used to run a second operating system (System_B). Dual-core communication may be performed between the two operating systems System_A and System_B through a bus such as SPI and UART.

The electronic device further includes a power-supply battery 550 (BATTERY), a power level measurement component 570, and a control switch 590. Here, the power level measurement component may include a fuel gauge (FG), but the disclosure is not limited thereto. The power-supply battery uniformly supplies power to the first operating system (System_A) and the second operating system (System_B) through a power supply bus. The fuel gauge FG is connected on the power supply bus. The fuel gauge may collect the charging current and discharging current of the power-supply battery through a CSP pin and a CSN pin, and calculate the remaining available power of the battery based on the charging current and discharging current; alternatively, it may collect the charging voltage and discharging voltage of the power-supply battery, and calculate the remaining available power of the battery based on the charging voltage and discharging voltage.

Each of the first operating system (System_A) and the second operating system (System_B) is connected to the control switch through an I2C bus. In other words, each of the first chip and the second chip is connected to the control switch through an I2C bus. Then, the control switch is connected to the same fuel gauge FG through an I2C bus. Therefore, the electronic device may control, through the control switch, System_A or System_B to be connected to the fuel gauge FG through the I2C bus.

Therefore, while the first operating system runs in the foreground of the electronic device, the control switch is used to control the first chip to be connected with the fuel gauge FG by default, the power level measurement component is then controlled to perform initialization and calculate the first power level information of the battery, and the first chip is controlled to acquire the first power level information of the battery. Since the first power level information calculated by the fuel gauge is closely related to the actual state of the battery, through the control switch, the first chip can be controlled to accurately obtain the first power level information of the battery from the fuel gauge FG.

The initialization of the power level measurement component controlled by the electronic device includes: collecting current ambient temperature information; collecting resistance information of the voltameter/fuel gauge; collecting the charging current and discharging current of the power-supply battery or the charging voltage and discharging voltage of the power-supply battery, through the CSP pin and CSN pin; and loading a battery calibration result. Here, the battery calibration result includes a battery calibration curve which represents a mapping relationship between the charging current and discharging current of the power-supply battery or the charging voltage and discharging voltage of the power-supply battery and the power level information of the battery under different ambient temperature information. For example, the battery calibration curve may be an SOC-OCV curve, but the disclosure is not limited thereto.

Then, after the initialization of the power level measurement component is completed, the electronic device may calculate the first power level information of the battery, based on the charging current and discharging current of the power-supply battery or the charging voltage and discharging voltage of the power-supply battery and the battery calibration curve, and control the first chip to acquire the first power level information of the battery through the I2C bus.

Subsequently, in response to the system switching instruction, the electronic device runs the second operating system in the foreground. And the electronic device generates the power level measurement component switching instruction in response to the system switching instruction. Then, in response to the power level measurement component switching instruction, the control switch controls the fuel gauge FG to be disconnected from the first chip and controls the fuel gauge FG to be connected with the second chip.

In the embodiments of the disclosure, the electronic device further includes a control switch. Each of the first chip and the second chip is connected to the control switch through an I2C bus, and the control switch is connected to a same power level measurement component through an I2C bus. Therefore, the electronic device can control, through the control switch, the first chip or the second chip to be connected to the same power level measurement component through the I2C bus, which control method is apparently simple and fast. Therefore, when the first operating system runs in the foreground of the electronic device, the control switch is used to control the first chip to be connected with the power level measurement component by default, the power level measurement component is then controlled to perform initialization and calculate the first power level information of the battery, and the first chip is controlled to acquire the first power level information of the battery. Subsequently, in response to the system switching instruction, the electronic device runs the second operating system in the foreground. And the electronic device generates a power level measurement component switching instruction in response to the system switching instruction. Then, in response to the power level measurement component switching instruction, the control switch controls the power level measurement component to be disconnected from the first chip and controls the power level measurement component to be connected with the second chip. In this way, the second chip is controlled to accurately acquire the second power level information of the battery directly from the power level measurement component.

In the previous embodiment, a process is described in which the electronic device uses the control switch to control the first chip to be connected with the power level measurement component and controls the power level measurement component to perform initialization and calculate the first power level information of the battery. In this embodiment, the provided power level display method further includes:
generating, by the first chip, the battery calibration result by calibrating the battery.

The operation of acquiring, by the first operating system, the power level information of the battery from the power level measurement component as the first power level information, includes:
controlling, by the first chip, the power level measurement component to perform initialization according to the battery calibration result, and after completion of the initialization of the power level measurement component, obtaining, through the power level measurement component, the power level information of the battery; and
acquiring the power level information of the battery as the first power level information.

In some implementations, before the electronic device obtains the power level information of the battery of the electronic device through the power level measurement component, the first chip calibrates the battery in advance to generate the battery calibration result. The battery calibration result includes a battery calibration curve which represents the mapping relationship between the charging current and discharging current of the power-supply battery or the charging voltage and discharging voltage of the power-supply battery and the power level information of the battery under different ambient temperature information. For example, the battery calibration curve may be an SOC-OCV curve, but the disclosure is not limited thereto.

Here, the first chip may use a constant current and constant voltage charging method to calibrate the battery. The process of calibrating the battery using the constant current and constant voltage charging method includes three steps: calibration, measurement, and evaluation. During the calibration process, the battery needs to be charged to a preset depth of charge under a constant voltage, and then the power of the battery is drained. During the measurement process, the battery needs to be charged to the preset depth of charge again, and then the power of the battery is drained. Finally, during the evaluation process, the actual capacity of the battery and other technical indicators are calculated to obtain the battery calibration result.

After the first chip calibrates the battery and obtains the battery calibration result, the first chip may control the power level measurement component to perform initialization according to the battery calibration result; and after the initialization of the power level measurement component is completed, the power level information of the battery may be obtained through the power level measurement component. In some implementations, the initialization of the power level measurement component controlled by the first chip includes: collecting current ambient temperature information; collecting resistance information of the voltameter/fuel gauge; collecting the charging current and discharging current of the power-supply battery or the charging voltage and discharging voltage of the power-supply battery, through the CSP pin and the CSN pin; and loading the battery calibration result.

Then, after the initialization of the power level measurement component is completed, the electronic device may obtain, through the power level measurement component, the power level information of the battery, based on the charging current and discharging current of the power-supply battery or the charging voltage and discharging voltage of the power-supply battery and the battery calibration curve. Exemplarily, the first chip may be connected to the control switch through I2C, and the control switch is in turn connected to the power level measurement component. Thus, the first chip may acquire the first power level information of the battery through the power level measurement component.

In the embodiments of the disclosure, the first chip calibrates the battery in advance to generate the battery calibration result. The battery calibration result includes the mapping relationship between the charging current and discharging current of the power-supply battery or the charging voltage and discharging voltage of the power-supply battery and the power level information of the battery. Then, the first chip may control the power level measurement component to perform initialization according to the battery calibration result, and after the initialization of the power level measurement component is completed, the power level information of the battery is obtained through the power level measurement component, and the power level information of the battery is taken as the first power level information. Since the first chip calibrates the battery in advance, and the power level measurement component is subsequently controlled to perform initialization according to the battery calibration result, the accuracy of the power level measurement component can be improved. Also, after the initialization of the power level measurement component is completed, the first chip can accurately calculate the first power level information of the battery.

In an embodiment, the provided power level display method further includes:
acquiring, by the second chip, the first power level information from the first chip, and taking the first power level information as the second power level information, where the first power level information is updated power level information of the battery acquired by the first chip based on the power level measurement component.

In some implementations, if the first chip is used as a chip currently connected to the power level measurement component, the first chip is controlled to acquire, from the power level measurement component, the first power level information of the battery in real time, and display the first power level information in the first operating system. Then, in response to the system switching instruction, the electronic device runs the second operating system in the foreground, and the second chip may acquire the first power level information from the first chip. In this case, the first power level information is the updated power level information of the battery acquired by the first chip based on the power level measurement component.

With respect to the acquisition of the first power level information by the second chip from the first chip, the second chip may actively acquires the first power level information from the first chip. Of course, the second chip may passively acquires the first power level information from the first chip, that is, the first chip actively sends the updated power level information of the battery obtained based on the power level measurement component to the second chip, and the disclosure is not limited thereto.

In the embodiments of the disclosure, if the first chip is used as the chip currently connected to the power level measurement component, the first chip is controlled to acquire the first power level information of the battery in real time from the power level measurement component, and display the acquired first power level information in the first operating system. Then, in response to the system switching instruction, the electronic device runs the second operating system in the foreground, and the second chip may acquire the first power level information from the first chip. In this case, the first power level information is the updated power level information of the battery acquired by the first chip based on the power level measurement component. That is, the first chip is always connected to the power level measurement component in the electronic device. And in this case, when the first operating system runs in the foreground of the electronic device, the first chip directly acquires the first power level information of the battery in real time from the power level measurement component, and displays the first power level information in the first operating system. And when the second operating system runs in the foreground of the electronic device, the second chip indirectly acquires, via the first chip, updated first power level information of the battery in real time from the power level measurement component, and takes the updated first power level information of the battery as the second power level information. In this way, the first operating system and the second operating system are also enabled to acquire power level information from the same power level measurement component. Thus, even if the system switching occurs, the power level information displayed in the two systems would not jump or change drastically.

In the previous embodiment, a process is described in which the second chip acquires the first power level information from the first chip and takes the first power level information as the second power level information. In this embodiment, it is further described that the first chip is in connection with the second chip, and the operation of acquiring, by the second chip, the first power level information from the first chip includes:
in response to the system switching instruction, sending, by the second chip, a request instruction to the first chip through the communication connection, the request instruction being used to instruct the first chip to send the first power level information to the second chip; and
receiving, by the second chip, the first power level information.

Here, an implementation is described in which the second chip acquires the first power level information from the first chip and takes the first power level information as the second power level information. The first chip and the second chip are connected through a preset communication manner, that is, the first chip and the second chip are connected through dual-core communication. Then, in response to the system switching instruction, the second chip acquires the first power level information of the battery from the first chip through the preset communication manner. The preset communication manner here is the dual-core communication. As illustrated in FIG. 5, dual-core communication may be performed between the two operating systems System_A and System_B through a bus such as SPI and UART. Therefore, the electronic device may control the second chip to acquire the first power level information of the battery from the first chip through the bus such as SPI and UART.

Exemplarily, in response to the system switching instruction, the second chip sends the request instruction to the first chip through the communication connection. The request instruction is used to instruct the first chip to send the first power level information to the second chip. In this way, the second chip may receive the first power level information.

In the embodiments of the disclosure, first, in response to the system switching instruction, the second chip sends a request instruction to the first chip through a preset communication manner. The request instruction is used to instruct the first chip to send the first power level information of the battery to the second chip. Then, after receiving the request instruction, the first chip sends the first power level information of the battery to the second chip. Finally, the second chip receives the first power level information of the battery. In this way, the second chip is enabled to acquire the first power level information of the battery from the first chip.

In the previous embodiment, an implementation of the second chip acquiring the first power level information from the first chip and taking the first power level information as the second power level information is described. Specifically, the second chip sends a request instruction to the first chip through a preset communication manner in response to the system switching instruction. Then, after receiving the request instruction, the first chip sends the first power level information of the battery to the second chip. In this embodiment, it is further described that the operation of the second chip acquiring the first power level information from the first chip further includes:
in response to the first power level information displayed in the first operating system being updated, sending, by the first chip, the updated first power level information to the second chip through the communication connection; and
receiving, by the second chip, the updated first power level information.

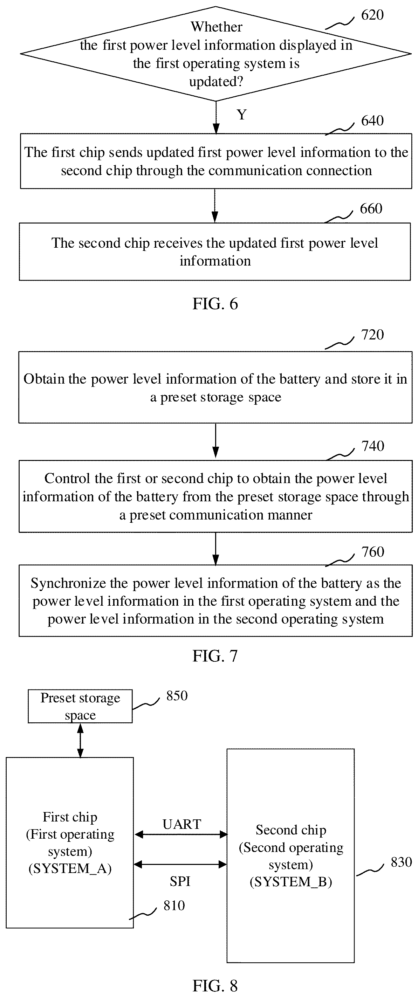

As illustrated in FIG. 6, the operation of the second chip acquiring the first power level information from the first chip includes following operations 620-660.

In operation 620, it is determined whether the first power level information displayed in the first operating system is updated.

In operation 640, when the first power level information displayed in the first operating system is updated, the first chip sends the updated first power level information to the second chip through the communication connection.

In operation 660, the second chip receives the updated first power level information.

Here, another implementation of the second chip acquiring the first power level information from the first chip and taking the first power level information as the second power level information is described. While the first operating system runs in the foreground of the electronic device, the first operating system acquires the power level information of the battery from the power level measurement component as first power level information, and displays the acquired first power level information in the first operating system. Therefore, the first operating system may monitor whether the acquired first power level information of the battery changes. If it is monitored that the first power level information of the battery is updated, the first chip sends the updated first power level information to the second chip through the communication connection. Then, the second chip receives the updated first power level information and updates the initial second power level information in the second chip according to the updated first power level information as new second power level information.

In the embodiments of the disclosure, while the first operating system runs in the foreground of the electronic device, the first operating system acquires the power level information of the battery from the power level measurement component as the first power level information, and displays the first power level information in the first operating system. Therefore, the first operating system may monitor whether the acquired first power level information of the battery changes. If it is monitored that the first power level information of the battery is updated, the first chip actively sends the updated first power level information to the second chip through the communication connection. Therefore, the second chip is enabled to acquire the first power level information from the first chip. In this way, the second chip does not need to continuously obtain the second power level information of the battery, but the first chip is controlled, when detecting that the first power level information of the battery changes, to send the first power level information of the battery to the second chip. Thus, while improving the accuracy of the power level information of the battery acquired by the second chip, the power consumption of the system is reduced.

In an embodiment, the provided power level display method further includes:
in response to the electronic device being switched from being in a shutdown state to being in a started state, obtaining a target operating system running in the foreground of the electronic device, the target operating system being the first operating system or the second operating system;
connecting a target chip corresponding to the target operating system to the power level measurement component; and
acquiring, by the target chip, the power level information of the battery from the power level measurement component as target power level information, and displaying the target power level information in the target operating system.

In some implementations, if the electronic device is switched from being in a shutdown state to being in a started state, generally, the electronic device may run a target operating system in the foreground in the started state. Here, the target operating system is the first operating system or the second operating system. That is, the electronic device may run the first operating system or the second operating system in the foreground in the started state.

Then, the target operating system running in the foreground at this time needs to display power level information, while the operating system running in the background does not need to display the power level information temporarily. Therefore, after the electronic device is switched from being in the shutdown state to being in the started state, the target chip corresponding to the target operating system may be directly connected to the power level measurement component. As such, the target chip may directly acquire, from the power level measurement component, the power level information of the battery as the target power level information, and display the target power level information in the target operating system. Apparently, in the case where the electronic device is switched from being in the shutdown state to being in the started state, there is no need to switch the connection between the power level measurement component and the target chip, thereby improving the efficiency of power level display and reducing the system power consumption.

In some implementations, after the electronic device is switched from being in the shutdown state to being in the started state, assuming that the MCU system runs in the foreground, the MCU system running in the foreground at this time needs to display the power level information, whereas the Android system running in the background does not need to display the power level information temporarily. Therefore, the first chip corresponding to the MCU system may be directly connected to the power level measurement component. The first chip is a Microcontroller Unit (MCU). In this way, the first chip may directly acquire, from the power level measurement component, the power level information of the battery as target power level information, and display the target power level information in the MCU system.

Similarly, after the electronic device is switched from being in the shutdown state to being in the started state, assuming that the Android system runs in the foreground, the Android system running in the foreground at this time needs to display the power level information, whereas the MCU system running in the background does not need to display the power level information temporarily. Therefore, the second chip corresponding to the Android system may be directly connected to the power level measurement component. The second chip is a System on Chip (SOC). In this way, the second chip may directly acquire, from the power level measurement component, the power level information of the battery as target power level information, and display the target power level information in the Android system.

In the embodiments of the disclosure, in the case where the electronic device is switched from being in the shutdown state to being in the started state, the target chip corresponding to the target operating system running in the foreground is directly connected to the power level measurement component. Thus, the target chip may directly acquire the power level information of the battery from the power level measurement component, and take it as target power level information. Finally, the target power level information is displayed in the target operating system. Apparently, there is no need to switch the connection between the power level measurement component and the target chip in this process, thereby improving the efficiency of power level display and reducing the system power consumption.

In an embodiment, the provided power level display method further includes:
in response to receiving, by the electronic device, a shutdown instruction while the power level measurement component is connected to the second chip, controlling the power level measurement component to be connected to the first chip.

In which, the power consumption produced when running the first operating system on the first chip is less than the power consumption produced when running the second operating system on the second chip.

When the electronic device receives a shutdown instruction in the started state, in response to the shutdown instruction, the electronic device first determines whether the power level measurement component is connected to the first chip. The power consumption produced when running the first operating system on the first chip is less than the power consumption produced when running the second operating system on the second chip. It may be understood that the first chip is a Microcontroller Unit (MCU), and the second chip is a System on Chip (SOC); correspondingly, the first operating system is an MCU system, and the second operating system is an Android system.

Since the power consumption produced when running the first operating system on the first chip is less than the power consumption produced when running the second operating system on the second chip, in response to the shutdown instruction, the electronic device may control the power level measurement component to be connected to the first chip. In this way, at the time of new starting up of the electronic device, the electronic device still keeps the power level measurement component connected to the first chip with lower power consumption, which can further reduce the system power consumption.

After determining whether the power level measurement component is connected to the first chip, if it is determined that the power level measurement component is connected to the second chip, the power level measurement component is controlled to be connected to the first chip. Exemplarily, the control switch is used to control the power level measurement component to be disconnected from the second chip and control the power level measurement component to be connected to the first chip. If it is determined that the power level measurement component is connected to the first chip, the power level measurement component is kept connected to the first chip. Finally, the electronic device executes the shutdown operation in response to the shutdown instruction.

In the embodiments of the disclosure, when the electronic device receives a shutdown instruction in the started state, in response to the shutdown instruction, the electronic device first determines whether the power level measurement component is connected to the first chip. If it is determined that the power level measurement component is connected to the second chip with higher power consumption, the power level measurement component is controlled to be connected to the first chip with lower power consumption. In this way, it is ensured that the power level measurement component is connected to the first chip with lower power consumption before the electronic device executes the shutdown operation. As such, at the time of next starting up of the electronic device, the electronic device still keeps the power level measurement component connected to the first chip with lower power consumption, which can further reduce the system power consumption.

In an embodiment, as illustrated in FIG. 7, a power level display method is provided, which includes operations 720-760.

In operation 720, the power level information of the battery is obtained and stored in a preset storage space.

In operation 740, the first chip or the second chip is controlled to obtain the power level information of the battery from the preset storage space through a preset communication manner.

In operation 760, the power level information of the battery is synchronized as the power level information in the first operating system and the power level information in the second operating system.

As illustrated in FIG. 8, a system architecture of an electronic device that synchronizes battery power level information in the first operating system and the second operating system according to an embodiment is shown. The electronic device includes a first chip 810 and a second chip 830. The first chip is used to run a first operating system (System_A), and the second chip is used to run a second operating system (System_B). Dual-core communication may be performed between the two operating systems System_A and System_B through a bus such as SPI and UART. And the first chip 810 may be in communication connection with a preset storage space 850.

Here, after the electronic device obtains the power level information of the battery, the power level information of the battery may be stored in the preset storage space. Here, a partition may be divided from the memory of any operating system in the electronic device as the preset storage space, or a partition may be divided from the memory of a commonly used operating system in the electronic device as the preset storage space, and the disclosure is not limited thereto.

For example, assuming that the first operating system is an MCU system, and since the power consumption of the MCU system is low, the MCU system may be used as a commonly used operating system in the electronic device. Therefore, a partition may be divided from the Nand-flash memory of the MCU system as the preset storage space (e.g., an NVRAM partition). The Nand-flash memory is a type of flash memory, and its interior adopts a non-linear macro-cell mode. The NVRAM partition stores data in the form of raw data, and may play a role in data backup. Here, the Nand-flash memory is only one type of memory in the MCU system, and the disclosure is not limited thereto.

Then, the first chip or the second chip is controlled to acquire the power level information of the battery from the preset storage space through a preset communication manner. Assuming that the power level information of the battery is stored in the preset storage space in the first operating system, the first chip may directly acquire the power level information of the battery from the preset storage space. Subsequently, the second chip is controlled to acquire the power level information of the battery from the preset storage space through the preset communication manner. That is, the second chip is controlled to acquire the power level information of the battery from the preset storage space through the dual-core communication (via a bus such as SPI and UART).

Since both the first chip and the second chip acquire the power level information of the battery from the same preset storage space, the power level information of the battery acquired by the first chip and the power level information of the battery acquired by the second chip are the same. Finally, the power level information of the battery is synchronized as the power level information in the first operating system and the power level information in the second operating system. Therefore, the consistency of the power level information in the first operating system and the power level information in the second operating system can be improved.

In some embodiments of the disclosure, when synchronizing the battery power level information between the first operating system and the second operating system, first, the power level information of the battery is obtained, and stored in a preset storage space. Then, the first chip or the second chip is controlled to acquire the power level information of the battery from the preset storage space through a preset communication manner. Since both the first chip and the second chip acquire the power level information of the battery from the same preset storage space, the power level information of the battery acquired by the first chip and the power level information of the battery acquired by the second chip are the same. Finally, the power level information of the battery is synchronized as the power level information in the first operating system and the power level information in the second operating system. Therefore, the consistency of the power level information in the first operating system and the power level information in the second operating system can be improved.

In the previous embodiments, a process is described in which the battery power level information is synchronized between the first operating system and the second operating system when the first operating system and the second operating system are in the enabled state, and the battery power level information is displayed in different operating systems. In this embodiment, it is further described that the electronic device further includes the power level measurement component, and the provided power level display method further includes:
in response to the first operating system being in the enabled state and the second operating system being in a disabled state, controlling the first chip to acquire the first power level information of the battery from the power level measurement component and display the first power level information in the first operating system.

The electronic device may detect the running states of the first operating system and the second operating system, where the running states include an enabled state or a disabled state. If it is detected that the first operating system is in the enabled state and the second operating system is in the disabled state, there is no need to display power level information in the second operating system since the second operating system is in the disabled state at this time. Then, it only needs to control the first chip to acquire the first power level information of the battery from the power level measurement component and display the first power level information in the first operating system.

With regard to controlling the first chip to acquire the first power level information of the battery from the power level measurement component, the control switch may be used to control the first chip to be connected to the fuel gauge FG, the power level measurement component may be then controlled to perform initialization and calculate the first power level information of the battery, and the first chip is controlled to acquire the first power level information of the battery. Since the power level information calculated by the fuel gauge is closely related to the actual state of the battery, the control switch may be used to control the first chip to accurately acquire the first power level information of the battery from the fuel gauge FG.

Then, the first chip may report the first power level information of the battery to the UI interface under the first operating system or the applications under the first operating system. Then, after receiving the first power level information of the battery under the first operating system, the UI interface under the first operating system may render and display the first power level information of the battery on the UI interface under the first operating system based on the first power level information.

In the embodiments of the disclosure, if it is detected that the first operating system is in the enabled state and the second operating system is in the disabled state, there is no need to display power level information in the second operating system since the second operating system is in the disabled state at this time. Then, it only needs to control the first chip to acquire the first power level information of the battery from the power level measurement component and display the first power level information in the first operating system. For the case where the first operating system is in the enabled state and the second operating system is the disabled state, real-time display of the first power level information in the first operating system is enabled.

In the previous embodiment, a process is described in which, when it is detected that the first operating system is in the enabled state and the second operating system is in the disabled state, the first chip is controlled to acquire the first power level information of the battery from the power level measurement component and display the first power level information in the first operating system. In this embodiment, the provided power level display method further includes:
in response to the first operating system being in the disabled state and the second operating system being in the enabled state, controlling the second chip to acquire the second power level information of the battery from the power level measurement component and display the second power level information in the second operating system.

The electronic device may detect the running states of the first operating system and the second operating system, and the running states include an enabled state or a disabled state. If it is detected that the second operating system is in the enabled state and the first operating system is in the disabled state, there is no need to display power level information in the first operating system since the first operating system is in the disabled state at this time. Then, it only needs to control the second chip to acquire the second power level information of the battery from the power level measurement component and display the second power level information in the second operating system.

With regard to controlling the second chip to acquire the second power level information of the battery from the power level measurement component, the control switch may be used to control the second chip to be connected to the fuel gauge FG, the power level measurement component is then controlled to perform initialization and calculate the second power level information of the battery, and the second chip is controlled to acquire the second power level information of the battery. Since the power level information calculated by the fuel gauge is closely related to the actual state of the battery, the control switch may be used to control the second chip to accurately acquire the second power level information of the battery from the fuel gauge FG.

Then, the second chip may report the second power level information of the battery to the UI interface under the second operating system or the applications under the second operating system. Then, after receiving the second power level information of the battery under the second operating system, the UI interface under the second operating system may render and display the second power level information of the battery on the UI interface under the second operating system based on the second power level information.

In the embodiments of the disclosure, if it is detected that the second operating system is in the enabled state and the first operating system is in the disabled state, there is no need to display power level information in the first operating system since the first operating system is in the disabled state at this time. Then, it only needs to control the second chip to acquire the second power level information of the battery from the power level measurement component and display the second power level information in the second operating system. For the case where the second operating system is in the enabled state and the first operating system is in the disabled state, real-time display of the second power level information in the second operating system is enabled.

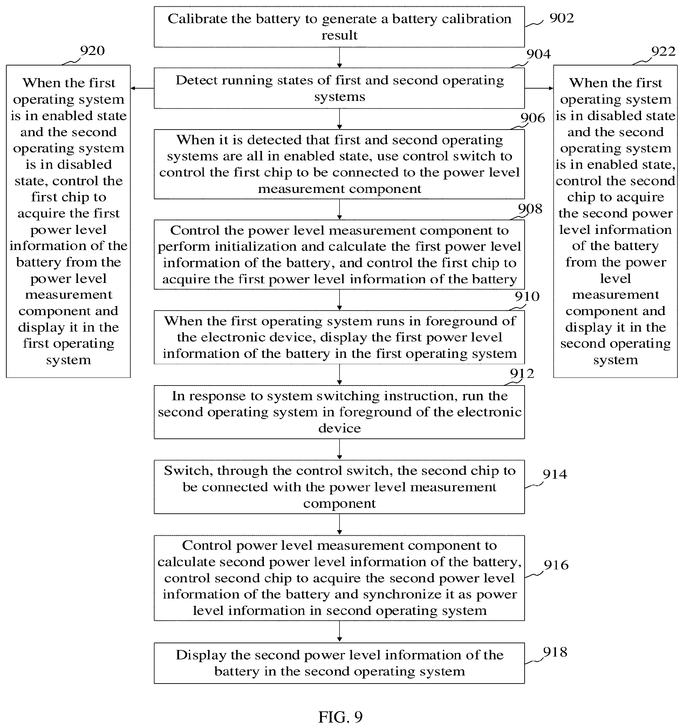

In an exemplary embodiment, the electronic device includes a first chip and a second chip. The first chip is used to run a first operating system, and the second chip is used to run a second operating system. The first chip is a Microcontroller Unit (MCU), and the second chip is a System on Chip (SOC); then, the first operating system is an MCU system, and the second operating system is an Android system. As illustrated in FIG. 9, a power level display method is provided, which includes operations 902-922.

In operation 902, the battery is calibrated to generate a battery calibration result.

In operation 904, the running states of the first operating system and the second operating system are detected.

In operation 906, when it is detected that the first operating system and the second operating system are all in an enabled state, the control switch is used to control the first chip to be connected to the power level measurement component.

In operation 908, the power level measurement component is controlled to perform initialization and calculate the first power level information of the battery, and the first chip is controlled to acquire the first power level information of the battery.

In operation 910, when the first operating system runs in foreground of the electronic device, the first power level information of the battery is displayed in the first operating system.

In operation 912, in response to a system switching instruction, the second operating system runs in foreground of the electronic device.

In operation 914, the second chip is switched, through the control switch, to be connected with the power level measurement component.

In operation 916, the power level measurement component is controlled to calculate the second power level information of the battery, the second chip is controlled to acquire the second power level information of the battery, and the second power level information is synchronized as the power level information in the second operating system.

In operation 918, the second power level information of the battery is displayed in the second operating system.

In operation 920, when the first operating system is in the enabled state and the second operating system is in the disabled state, the first chip is controlled to acquire the first power level information of the battery from the power level measurement component and display the first power level information in the first operating system.

In operation 922, when the first operating system is in the disabled state and the second operating system is in the enabled state, the second chip is controlled to acquire the second power level information of the battery from the power level measurement component and display the second power level information in the second operating system.

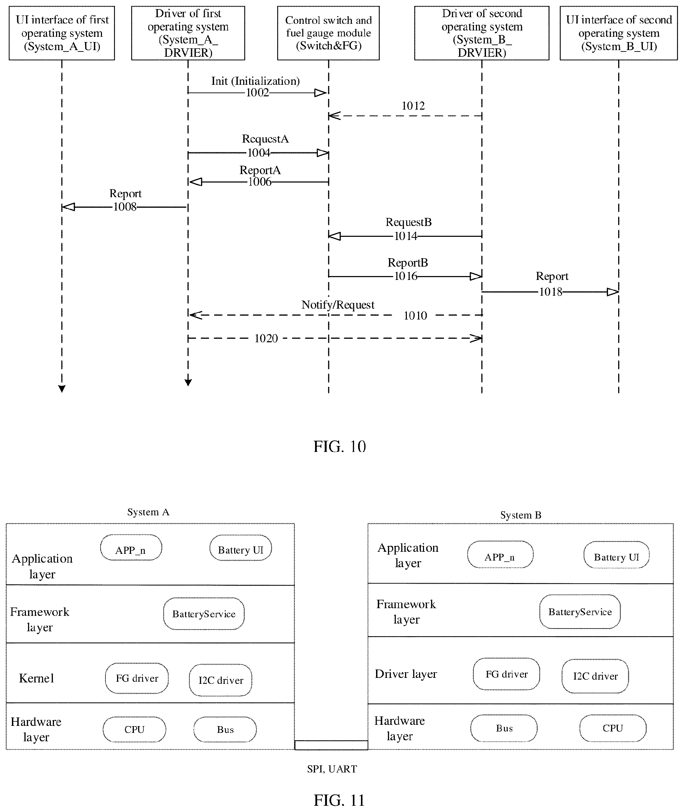

As illustrated in FIG. 10, a signaling sequence at which the electronic device synchronizes battery power level information in the first operating system and the second operating system according to an embodiment is shown. As illustrated in FIG. 10, the electronic device includes an interface of the first operating system (System_A_UI), a driver of the first operating system (System_A_Driver), a control switch and fuel gauge module, a driver of the second operating system (System_B_Driver), and an interface of the second operating system (System_B_UI). Here, if the electronic device uses the control switch to control the first chip to be connected to the fuel gauge FG through an I2C bus, a power level display method is provided, which includes operations 1002-1010.

In operation 1002, the first chip is connected to the power level measurement component under control of the control switch, and the power level measurement component is controlled to perform initialization and calculate the first power level information of the battery.

In operation 1004, the driver of the first operating system (System_A_Driver) is controlled to send a first request RequestA to the control switch and fuel gauge module, where the first request is used to acquire the first power level information of the battery from the control switch and fuel gauge module.

In operation 1006, the control switch and fuel gauge module send a first report ReportA to the driver of the first operating system (System_A_Driver), where the first report ReportA carries the first power level information of the battery.

In operation 1008, the driver of the first operating system (System_A_Driver) is controlled to send the first report ReportA to the interface of the first operating system (System_A_UI), and the first power level information of the battery may be displayed in the interface of the first operating system (System_A_UI).

In operation 1010, the driver of the second operating system (System_B_Driver) is controlled to acquire the first power level information of the battery from the driver of the first operating system (System_A_Driver) through a Notify/Request (notification/request), and the first power level information is taken as the power level information in the second operating system, the first power level information of the battery may be displayed in the interface of the second operating system (System_B_UI).

Here, if the electronic device uses the control switch to control the second chip to be connected to the fuel gauge FG through an I2C bus, in this case, a power level display method is provided, which includes operations 1012-1020.

In operation 1012, the second chip is connected to the power level measurement component under control of the control switch, and the power level measurement component is controlled to perform initialization and calculate the second power level information of the battery.

In operation 1014, the driver of the second operating system (System_B_Driver) is controlled to send a second request RequestB to the control switch and fuel gauge module, where the second request is used to acquire the second power level information of the battery from the control switch and fuel gauge module.

In operation 1016, the control switch and fuel gauge module send a second report ReportB to the driver of the second operating system (System_B_Driver), where the second report ReportB carries the second power level information of the battery.

In operation 1018, the driver of the second operating system (System_B_Driver) is controlled to send the second report ReportB to the interface of the second operating system (System_B_UI), and the second power level information of the battery may be displayed in the interface of the second operating system (System_B_UI).

In operation 1020, the driver of the first operating system (System_A_Driver) is controlled to acquire the second power level information of the battery from the driver of the second operating system (System_B_Driver) in a Notify/Request (notification/request), and take the second power level information as the power level information in the first operating system, where the second power level information of the battery may be displayed in the interface of the first operating system (System_A_UI).

As illustrated in FIG. 11, a schematic system architecture of the electronic device according to an embodiment is shown. The entire system of the electronic device may include four layers, involving a hardware layer, a kernel or driver layer, a framework layer, and an application layer. The hardware layer provides hardware capabilities such as power supply, SPI, and UART bus for the entire system, including a CPU and a bus. The kernel or driver layer includes drivers for various buses (I2C driver), a driver for a switch, a driver for the fuel gauge FG, a battery file PROFILE, charging process management, power calculation, etc. The kernel or driver layer also includes dual-core communication bus drivers such as SPI or UART driver. The framework layer mainly serves as a link between the driver layer and the application layer, manages application requests and driver messages, and implements information synchronization management during dual-core communication, such as a battery management service BatteryService. The application layer mainly performs interface display, processes the logic processing and response of user interaction operations, and includes various applications APP_n and a battery display UI interface Battery UI.

In the embodiments, the electronic device may use the control switch to control the first chip to be connected to the power level measurement component, then control the power level measurement component to perform initialization and calculate the first power level information of the battery. Finally, the first chip acquires the first power level information of the battery. In this way, the first chip is enabled to accurately acquire the first power level information of the battery directly from the power level measurement component. The electronic device may control the control switch to switch the second chip to be connected to the power level measurement component, then control the power level measurement component to perform initialization and calculate the second power level information of the battery. Finally, the second chip may also acquire the second power level information of the battery. In this way, the second chip is enabled to accurately acquire the second power level information of the battery directly from the power level measurement component. Both the first operating system and the second operating system obtain the battery power level information from the same power level measurement component. Therefore, the battery power level information obtained in the first operating system and the battery power level information obtained in the second operating system are consistent. Thus, at the time of switching between the two systems, the power level information displayed in the two systems would not jump or change drastically. Finally, the electronic device is enabled to maintain smooth and stable power level display throughout the entire power level display process.

It is understood that, although the operations in the above flowcharts are displayed in sequence according to the arrows, these operations are not necessarily executed in sequence according to the arrow directions. Unless explicitly stated herein, these operations are not executed in a strict order, and they may be executed in other orders. Moreover, at least part of the operations in the above flowcharts may include multiple sub-operations or multiple stages. These sub-operations or stages are not necessarily executed at the same time, but may be executed at different times. These sub-operations or stages are not necessarily executed in sequence, but may be executed in turn or alternately with at least part of the sub-operations or stages of other operations.

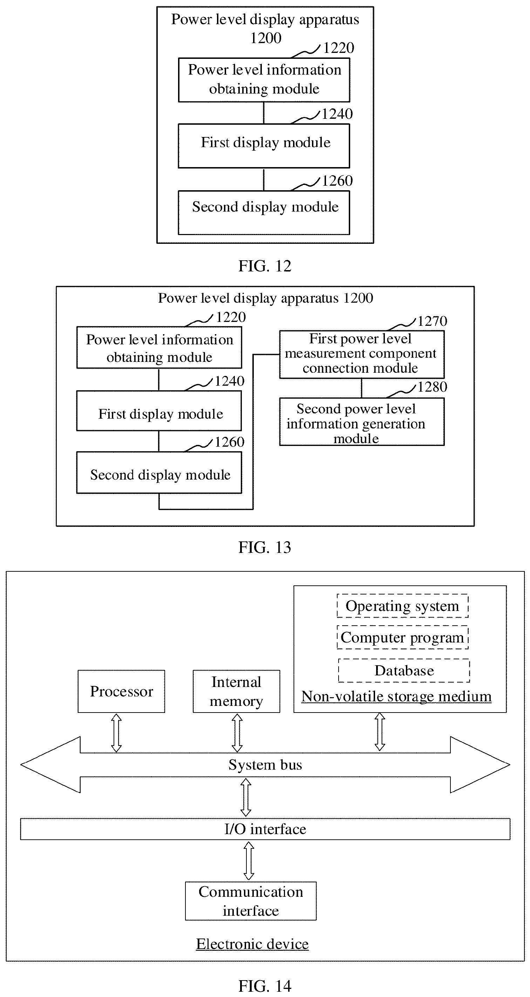

Based on the same inventive concept, as illustrated in FIG. 12, a power level display apparatus 1200 is provided, which is implemented in an electronic device. The electronic device includes a first chip and a second chip, where the first chip is used to run a first operating system, and the second chip is used to run a second operating system. The electronic device further includes a power level measurement component, and the first chip is connected to the power level measurement component. The apparatus includes a power level information obtaining module 1220, a first display module 1240, and a second display module 1260.

The power level information obtaining module 1220 is configured to obtain power level information of a battery of the electronic device through the power level measurement component.

The first display module 1240 is configured to, when the first operating system and the second operating system are all in an enabled state and the first operating system runs in the foreground of the electronic device, enable the first operating system to acquire, from the power level measurement component, the power level information of the battery as first power level information, and display the first power level information in the first operating system.

The second display module 1260 is configured to, in response to a system switching instruction, enable the electronic device to run the second operating system in the foreground, and display second power level information in the second operating system, where the second power level information is acquired based on updated power level information of the battery obtained by the power level measurement component.

In an embodiment, as illustrated in FIG. 13, the provided power level display apparatus 1200 further includes a first power level measurement component connection module 1270 and a second power level information generation module 1280.

The first power level measurement component connection module 1270 is configured to, in response to the system switching instruction, disconnect the power level measurement component from the first chip and connect the power level measurement component to the second chip.

The second power level information generation module 1280 is configured to enable the second chip to acquire updated power level information of the battery from the power level measurement component, and take the updated power level information of the battery as the second power level information.

In an embodiment, the electronic device further includes a control switch connected to the power level measurement component. The first power level measurement component connection module 1270 is further configured to: generate a power level measurement component switching instruction in response to the system switching instruction; and in response to the power level measurement component switching instruction, control, through the control switch, the power level measurement component to be disconnected from the first chip and to be connected to the second chip.

In an embodiment, the first power level measurement component connection module 1270 is further configured to, in response to the system switching instruction, detect whether the second operating system runs in the foreground of the electronic device; and generate the power level measurement component switching instruction when it is detected that the second operating system runs in the foreground of the electronic device.

In an embodiment, as illustrated in FIG. 13, the second power level information generation module 1280 is further configured to enable the second chip to acquire the first power level information from the first chip, and take the first power level information as the second power level information, where the first power level information is the updated power level information of the battery obtained by the first chip based on the power level measurement component.

In an embodiment, the first chip is in communication connection with the second chip, and the second power level information generation module 1280 is further configured to, in response to the system switching instruction, enable the second chip to send a request instruction to the first chip through the communication connection, the request instruction is used to instruct the first chip to send the first power level information to the second chip; and enable the second chip to receive the first power level information and take the first power level information as the second power level information.

In an embodiment, the second power level information generation module 1280 is further configured to, when the first power level information displayed in the first operating system is updated, enable the first chip to send the updated first power level information to the second chip through the communication connection; and enable the second chip to receive the updated first power level information and take the updated first power level information as the second power level information.

In an embodiment, the provided power level display apparatus further includes:
a battery calibration module, configured to enable the first chip to calibrate the battery to generate a battery calibration result.

The first display module 1240 is further configured to enable the first chip to control the power level measurement component to perform initialization according to the battery calibration result, and after completion of the initialization of the power level measurement component, obtain the power level information of the battery through the power level measurement component, and acquire the power level information of the battery as the first power level information.

In an embodiment, the provided power level display apparatus further includes a target operating system acquisition module, a second power level measurement component connection module, and a target power level information display module.

The target operating system acquisition module is configured to obtain a target operating system running in the foreground of the electronic device in response to the electronic device being switched from being in a shutdown state to being in a started state, the target operating system is the first operating system or the second operating system.

The second power level measurement component connection module is configured to connect a target chip corresponding to the target operating system to the power level measurement component.

The target power level information display module is configured to enable the target chip to acquire, from the power level measurement component, the power level information of the battery as target power level information and display the target power level information in the target operating system.

In an embodiment, the provided power level display apparatus further includes:
a third power level measurement component connection module, configured to control the power level measurement component to be connected to the first chip, in a case where the electronic device receives a shutdown instruction and the power level measurement component is connected to the second chip.

In which, the power consumption produced when running the first operating system on the first chip is less than the power consumption produced when running the second operating system on the second chip.

In an embodiment, the power consumption produced when running the first operating system on the first chip is less than the power consumption produced when running the second operating system on the second chip;

Alternatively, the power consumption produced when running the first operating system on the first chip is greater than or equal to the power consumption produced when running the second operating system on the second chip.

The division of each module in the above power level display apparatuses is only illustrative. In other embodiments, the power level display apparatus may be divided into different modules as needed to complete all or part of the functions of the above power level display apparatuses.

For specific definitions of the power level display apparatuses, reference may be made to the above definitions of the power level display methods, which will not be repeated here. Each module in the above power level display apparatuses may be fully or partially implemented by software, hardware, or a combination thereof. The above modules may be in the form of hardware and embedded in or independent of the processor of the computer device, or may be in the form of software and stored in the memory of the computer device, so that the processor may call and execute the operations corresponding to the above modules.

FIG. 14 schematically illustrates an internal structure of an electronic device according to an embodiment. The electronic device may be any terminal device such as a mobile phone, a tablet computer, a notebook computer, a desktop computer, a Personal Digital Assistant (PDA), Point of Sales (POS), an in-vehicle computer, or a wearable device. The electronic device includes a processor and a memory connected through a system bus. The processor may include one or more processing units. The processor may be a Central Processing Unit (CPU) or a Digital Signal Processing (DSP) and the like. The memory may include a non-volatile storage medium and an internal memory. The non-volatile storage medium stores an operating system and a computer program. The computer program may be executed by the processor to implement the power level display method provided in the following various embodiments. The internal memory provides a high-speed cache running environment for the operating system and the computer program in the non-volatile storage medium.

Various modules in the power level display apparatuses provided in the embodiments of the disclosure may be implemented in the form of a computer program. The computer program may run on an electronic device. Program modules formed by the computer program may be stored in the memory of the electronic device. When the computer program is executed by the processor, the operations of the method described in the embodiments of the disclosure are implemented.

The embodiments of the disclosure further provide a computer-readable storage medium. One or more non-volatile computer-readable storage media containing computer-executable instructions. The computer-executable instructions, when being executed by one or more processors, cause the one or processors to execute the operations of the power level display method(s).

The embodiments of the disclosure further provide a computer program product containing instructions which, when running on a computer, cause the computer to execute the power level display method(s).

Any mentioned memory, storage, database, or other medium used in the disclosure may include non-volatile and/or volatile memory. The non-volatile memory may include Read-Only Memory (ROM), Programmable Read-Only Memory (PROM), Erasable Programmable Read-Only Memory (EPROM), Electrically Erasable Programmable Read-Only Memory (EEPROM), or flash memory. The volatile memory may include Random Access Memory (RAM), which acts as an external high-speed cache. By way of illustration and not limitation, RAM is available in various forms such as Static Random Access Memory (SRAM), Dynamic Random Access Memory (DRAM), Synchronous Dynamic Random Access Memory (SDRAM), Double Data Rate Synchronous Dynamic Random Access Memory (DDR SDRAM), Enhanced Synchronous Dynamic Random Access Memory (ESDRAM), Sync Link Dynamic Random Access Memory (SLDRAM), Rambus Dynamic Random Access Memory (RDRAM), and Direct Rambus Dynamic Random Access Memory (DRDRAM).

The technical features of the above-mentioned embodiments may be combined arbitrarily. To make the description concise, not all possible combinations of the technical features in the above-mentioned embodiments are described. However, as long as there is no contradiction in the combination of these technical features, they should be considered as falling within the scope of the present specification.

The above-mentioned embodiments only illustrate several implementations of the disclosure, and their descriptions are specific and detailed, but they should not be construed as limiting the scope of the disclosure. It is noted that, several modifications and improvements can be made by those of ordinary skill in the art without departing from the concept of the disclosure, and these all fall within the protection scope of the disclosure. Therefore, the scope of protection of the disclosure should be subject to the appended claims.

## Claims

1. A power level display method, implemented by an electronic device, wherein the electronic device comprises a first chip and a second chip, the first chip is configured to run a first operating system, the second chip is configured to run a second operating system, the electronic device further comprises a power level measurement component connected with the first chip, and the method comprises:
obtaining, through the power level measurement component, power level information of a battery of the electronic device;
in a case where the first operating system and the second operating system are all in an enabled state and the first operating system runs in foreground of the electronic device, acquiring, by the first operating system, the power level information of the battery from the power level measurement component as first power level information, and displaying the first power level information in the first operating system; and
in response to a system switching instruction, running the second operating system in the foreground of the electronic device, and displaying second power level information in the second operating system, wherein the second power level information is acquired based on updated power level information of the battery obtained by the power level measurement component.

2. The method of claim 1, further comprising:
in response to the system switching instruction, disconnecting the power level measurement component from the first chip, and connecting the power level measurement component to the second chip; and
acquiring, by the second chip, the updated power level information of the battery from the power level measurement component, and taking the updated power level information of the battery as the second power level information.

3. The method of claim 2, wherein the electronic device further includes a control switch connected with the power level measurement component, and the disconnecting the power level measurement component from the first chip and connecting the power level measurement component to the second chip in response to the system switching instruction, comprises:
generating a power level measurement component switching instruction, in response to the system switching instruction; and
in response to the power level measurement component switching instruction, controlling, through the control switch, the power level measurement component to be disconnected from the first chip and to be connected to the second chip.

4. The method of claim 3, wherein the generating the power level measurement component switching instruction in response to the system switching instruction comprises:
in response to the system switching instruction, detecting whether the second operating system runs in the foreground of the electronic device; and
in a case where the second operating system runs in the foreground of the electronic device, generating the power level measurement component switching instruction.

5. The method of claim 1, further comprising:
acquiring, by the second chip, the first power level information from the first chip, and taking the first power level information as the second power level information, wherein the first power level information is updated power level information of the battery acquired by the first chip based on the power level measurement component.

6. The method of claim 5, wherein the first chip is in communication connection with the second chip, and the acquiring, by the second chip, the first power level information from the first chip and taking the first power level information as the second power level information comprises:
in response to the system switching instruction, sending, by the second chip, a request instruction to the first chip through the communication connection, the request instruction being used to instruct the first chip to send the first power level information to the second chip; and
receiving, by the second chip, the first power level information, and taking the first power level information as the second power level information.

7. The method of claim 5, wherein the acquiring, by the second chip, the first power level information from the first chip and taking the first power level information as the second power level information further comprises:
in a case where the first power level information displayed in the first operating system is updated, sending, by the first chip, updated first power level information to the second chip through the communication connection; and
receiving, by the second chip, the updated first power level information, and taking the updated first power level information as the second power level information.

8. The method of claim 1, further comprises:
generating, by the first chip, a battery calibration result by calibrating the battery; and
the acquiring, by the first operating system, the power level information of the battery from the power level measurement component as the first power level information comprises:
controlling, by the first chip, the power level measurement component to perform initialization according to the battery calibration result, and obtain the power level information of the battery after completion of the initialization of the power level measurement component; and
acquiring the power level information of the battery as the first power level information.

9. The method of claim 2, further comprising:
in a case where the electronic device is switched from being in a shutdown state to being in a started state, obtaining a target operating system running in the foreground of the electronic device, the target operating system being the first operating system or the second operating system;
connecting a target chip corresponding to the target operating system to the power level measurement component; and
acquiring, by the target chip, the power level information of the battery from the power level measurement component as target power level information, and displaying the target power level information in the target operating system.

10. The method of claim 2, further comprising:
in a case where the electronic device receives a shutdown instruction and the power level measurement component is connected to the second chip, controlling the power level measurement component to be connected to the first chip;
wherein a power consumption produced when running the first operating system on the first chip is less than a power consumption produced when running the second operating system on the second chip.

11. The method of any one of claims 1-9, wherein a power consumption produced when running the first operating system on the first chip is less than a power consumption produced when running the second operating system on the second chip; or
the power consumption produced when running the first operating system on the first chip is greater than or equal to the power consumption produced when running the second operating system on the second chip.

12. The method of claim 1, wherein the power level measurement component comprises a voltameter.

13. The method of claim 1, wherein the power level information comprises at least one of information on remaining available power of the battery, a power mode of the battery, information on state of charge of the battery, lifespan information of the battery, and a total capacity of the battery.

14. The method of claim 13, wherein the power mode of the battery comprises a normal mode, a power-saving mode, and an ultra-power-saving mode; in the normal mode of the battery of the electronic device, all applications on the electronic device are capable of being started normally; in the power-saving mode of the battery of the electronic device, some applications on the electronic device are capable of being started normally; and in the ultra-power-saving mode of the battery of the electronic device, applications supporting basic system functions of the electronic device are capable of being started normally, and other applications are incapable of being started.

15. The method of claim 1, wherein the first operating system and the second operating system are different operating systems.

16. The method of claim 1, wherein the system switching instruction is an instruction sent from the first operating system to the second operating system;
the system switching instruction carries wake-up information, and the second operating system is woken up based on the wake-up information.

17. A power level display apparatus, implemented in an electronic device, wherein the electronic device comprises a first chip and a second chip, the first chip is configured to run a first operating system, the second chip is configured to run a second operating system, the electronic device further comprises a power level measurement component connected with the first chip, and the apparatus comprises:
a power level information obtaining module, configured to obtain, through the power level measurement component, power level information of a battery of the electronic device;
a first display module, configured to, when the first operating system and the second operating system are in an enabled state and the first operating system runs in foreground of the electronic device, enable the first operating system to acquire the power level information of the battery from the power level measurement component as first power level information, and display the first power level information in the first operating system; and
a second display module, configured to, in response to a system switching instruction, enable the second operating system to run in the foreground of the electronic device, and display second power level information in the second operating system, wherein the second power level information is acquired based on updated power level information of the battery obtained by the power level measurement component.

18. An electronic device, comprising a memory and a processor, wherein the memory stores therein a computer program which, when being executed by the processor, causes the processor to implement operations of the power level display method of any one of claims 1-16.

19. A computer-readable storage medium having a computer program stored thereon, wherein the computer program, when being executed by a processor, causes operations of the power level display method of any one of claims 1-16 to be implemented.

20. A computer program product comprising a computer program, wherein the computer program, when being executed by a processor, causes operations of the power level display method of any one of claims 1-16 to be implemented.
